# EUROPEAN PATENT SPECIFICATION

(11) **EP 2 613 164 B1**
(45) Date of publication and mention of the grant of the patent: **14.01.2015**
(21) Application number: 12768370.4
(22) Date of filing: 06.04.2012
(51) Int. Cl.: G01R 31/02, G01R 21/00, H01M 8/04, H02J 3/38, H02M 7/48, G01R 35/00, G01R 35/04

(54) **DISTRIBUTED POWER GENERATION DEVICE AND METHOD FOR OPERATING SAME**
VORRICHTUNG ZUR ERZEUGUNG EINER VERTEILTEN LEISTUNG UND BETRIEBSVERFAHREN DAFÜR
DISPOSITIF DE GÉNÉRATION D'ÉNERGIE DISTRIBUÉE ET PROCÉDÉ POUR SON FONCTIONNEMENT

(30) Priority: 08.04.2011 JP 2011086031
(43) Date of publication of application: 10.07.2013
(73) Proprietor: Panasonic Corporation, Osaka 571-8501 (JP)
(72) Inventor: KAKU, Hiroaki, Osaka 540-6207 (JP)
(74) Representative: Grünecker, Kinkeldey, Stockmair & Schwanhäusser
(86) International application number: PCT/JP2012/002439
(87) International publication number: WO 2012/137516

(56) References cited:
- JP-A- 4 225 172
- JP-A- H04 225 172
- JP-A- 2002 286 785
- JP-A- 2002 286 785
- JP-A- 2003 189 425
- JP-A- 2004 297 959
- JP-A- 2004 297 959
- US-A1- 2004 189 315
- US-A1- 2009 140 745
- DATABASE WPI Week 200935 Thomson Scientific, London, GB; AN 2009-J03818 XP002699487, -& CN 201 226 024 Y (HEILONGJIANG ELECTRIC POWER RES INST) 22 April 2009 (2009-04-22)
- DATABASE WPI Week 201029 Thomson Scientific, London, GB; AN 2010-E46293 XP002699488, -& CN 101 685 147 A (HEILONGJIANG ELECTRIC POWER RES INST) 31 March 2010 (2010-03-31)

## Description

### Technical Field

The present invention relates to a distributed power generation system which is interactively connected (interconnected) to a power supply utility and supplies AC power (AC electric power) to the power supply utility and to an AC power load, and an operation method thereof. Particularly, the present invention relates to a distributed power generation system which detects an abnormality of a measurement device for measuring the electric power from the power supply utility, and an operation method thereof.

### Background Art

Conventionally, a distributed power generation system including a configuration for making determination as to a connection abnormality of a current detector (see Patent Literature 1). Fig. 9 is a block diagram showing a configuration of the conventional distribution power generation system disclosed in Patent Literature 1.

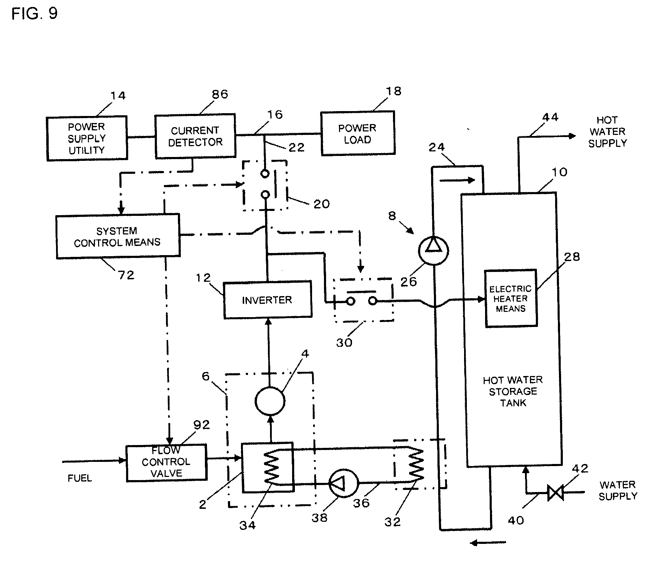

As shown in Fig. 9, the conventional distributed power generation system includes a generator 4, a utility interactive inverter 12, a current detector 86, a system control means 72, etc.. The generator 4 is a generator actuated by an engine 2. The utility interactive inverter 12 converts the electric power generated in the generator 4 into a voltage and a frequency which are the same as those of utility electric power supplied from a power supply utility 14. The utility interactive inverter 12 supplies the converted electric power to a utility distribution line 16 extending from the power supply utility 14 to a power load 18 via a utility interconnection distribution line 22. The current detector 86 detects a current flowing through the utility distribution line 16. The system control means 72 controls the electric power supplied from the generator 4 to the utility distribution line 16 via the utility interactive inverter 12 and the utility interconnection distribution line 22, and diagnoses a connected state of the current detector 86, by utilizing the detected current of the current detector 86.

The system control means 72 in the above stated distributed power generation system diagnoses the connected state of the current detector 86 by changing electric power output from the utility interactive inverter 12 during a power generation operation. For example, if the amount of the fuel supplied to the engine 2 increases (or decreases) in accordance with a command issued from the system control means 72, an output of the engine 2 increases (decreases), electric power output from the generator 4 increases (or decreases), and electric power output from the utility interactive inverter 12 increases (or decreases).

The system control means 72 determines whether or not a current value detected by the current detector 86 changes synchronously with a change in the electric power output from the utility interactive inverter 12. Specifically, if the electric power output from the utility interactive inverter 12 increases (or decreases), the system control means 72 determines whether or not the current value detected by the current detector 86 decreases (or increases) synchronously with the increase/decrease in the electric power output from the utility interactive inverter 12. If it is determined that the detected current value changes synchronously with the change in the electric power output from the utility interactive inverter 12, the system control means 72 determines that the current detector 86 is connected correctly. On the other hand, if the current value detected by the current detector 86 does not change synchronously with the change in the electric power output from the utility interactive inverter 12, the system control means 72 determines that there is an abnormality in the connected state of the current detector 86.

### Citation Lists

### Patent Literature

Patent Literature 1: Japanese Laid-Open Patent Application Publication No. 2002-286785

CN 201 226 024 Y relates to a test device for simulating on-site electric energy metering. CN 101 685 147 A relates to a test device and method for simulating field electric energy measurement. JP H04 225172 A relates to a method for testing the direction of voltage/current. JP 2002 286785 A relates to a diagnostic device of a cogeneration system. JP 2004 297959 A relates to a private power generation system.

### Summary of the Invention

### Technical Problem

In the above stated conventional distributed power generation system, to diagnose the connected state of the current detector 86, the output of the engine 2 must be controlled. However, in the case of controlling the output of the engine 2, various components to be operated must be controlled, for example, a flow rate of a fuel must be adjusted, an ignition timing of an ignition plug must be adjusted, etc.. If the diagnostic process is executed during a rated operation of the engine 2, the output of the engine 2 must be decreased temporarily (for a specified time). In this case, the electric power output from the generator 4 decreases, and the electric power output from the utility interactive inverter 12 also decreases. As a result, an amount of electric power supplied from the distributed power generation system to the power load 18 decreases.

The present invention has been developed to solve the above mentioned problems, and an object of the present invention is to provide a distributed power generation system which is capable of detecting an abnormality of a power measuring device for measuring electric power supplied from a power supply utility to which the distributed power generation system is interactively connected, with an easy operation, and an operation method thereof. Another object of the present invention is to provide a distributed power generation system which is capable of detecting an abnormality of a power measuring device without reducing an amount of the electric power supplied from the distributed power generation system to a power load, and an operation method thereof.

### Solution to Problem

According to the present invention, there is provided a distributed power generation system interactively connected to a power supply utility as defined in claim 1.

According to the present invention, there is provided a method of operating a distributed power generation system as defined in claim 9.

In such a configuration, by an easy operation, it is possible to detect an abnormality of a power measuring device for measuring electric power supplied from a power supply utility interactively connected to a distributed power generation system.

### Advantageous Effects of the Invention

A distributed power generation system and an operation method of the present invention can detect an abnormality of a power measuring device for measuring electric power supplied from a power supply utility interactively connected to the distributed power generation system, by an easy operation.

### Brief Description of the Drawings

[Fig. 1] Fig. 1 is a block diagram of a distributed power generation system according to Embodiment 1 of the present invention.
[Fig. 2] Fig. 2 is a flowchart showing a diagnostic process of a connected state of a current detector which is performed by the distributed power generation system according to Embodiment 1.
[Fig. 3] Fig. 3 is a flowchart showing a modified example of the diagnostic process of the connected state of the current detector which is performed by the distributed power generation system according to Embodiment 1.
[Fig. 4] Fig. 4 is a block diagram of a distributed power generation system according to Embodiment 2 of the present invention.
[Fig. 5] Fig. 5 is a graph showing an example of a relation of a phase difference between a voltage and a current which are measured by a power measuring device according to Embodiment 2.
[Fig. 6] Fig. 6 is a flowchart showing a diagnostic process of a connected state of a current detector which is performed by the distributed power generation system according to Embodiment 2.
[Fig. 7] Fig. 7 is a block diagram of a distributed power generation system according to Embodiment 3 of the present invention.
[Fig. 8] Fig. 8 is a flowchart showing a diagnostic process of a connected state of a current detector which is performed by the distributed power generation system according to Embodiment 3.
[Fig. 9] Fig. 9 is a block diagram showing a configuration of a conventional distributed power generation system.

### Description of the Invention

According to the present invention, there is provided a distributed power generation system interactively connected to a power supply utility, comprising: a power generation unit for generating DC power; a power converter which converts the DC power from the power generation unit into AC power (hereinafter referred to as first power) and outputs the first power to a power load; a power measuring device for measuring electric power (hereinafter referred to as second power) supplied from the power supply utility to the power load; and an abnormality detector for detecting an abnormality of the power measuring device; wherein the power measuring device includes a current measuring device for measuring a current value of the second power and a voltage measuring device for measuring a voltage value between electric wires connecting the power converter to the power supply utility; and the abnormality detector detects the abnormality of the power measuring device based on a change in reactive power of the first power and a change in the second power measured by the power measuring device, when the reactive power of the first power is changed.

Thus, it is possible to determine an abnormality of a power measuring device mainly by control performed with respect to the power converter, without controlling the power generation unit, for example. That is, by an easy operation, the distributed power generation system of the present invention can detect the abnormality of the power measuring device for measuring electric power supplied from the power supply utility interactively connected to the distributed power generation system.

In the distributed power generation system, the abnormality detector may adjust a magnitude of a current of the first power and a phase difference between the current and a voltage of the first power such that active power of the first power is constant before and after changing the reactive power.

Thus, the abnormality of the power measuring device can be detected without reducing the electric power generated in the power generation unit, i.e., without reducing the amount of electric power supplied from the distributed power generation system to the power load.

In the distributed power generation system, the abnormality detector may determine that the power measuring device has an abnormality when a change amount of the second power measured by the power measuring device in a case where a change in the reactive power of the first power occurs is equal to or less than a predetermined threshold.

Thus, misdetermination can be suppressed even when a transient change occurs in the current detected by the power measuring device, due to a noise, etc.. Therefore, reliability of a result of detected abnormality of the power measuring device can be improved.

In the distributed power generation system, the abnormality detector may detect the abnormality of the power measuring device, based on a change in a magnitude of a current of the second power which is measured by the power measuring device, before and after changing the reactive power of the first power.

In the distributed power generation system, the abnormality detector may detect the abnormality of the power measuring device, based on a change in a phase difference between a current and a voltage of the second power which is measured by the power measuring device, before and after changing the reactive power of the first power.

In the distributed power generation system, the abnormality detector may detect the abnormality of the power measuring device, based on a change in the reactive power of the second power which is measured by the power measuring device, before and after changing the reactive power of the first power.

In the distributed power generation system, the abnormality detector may detect the abnormality of the power measuring device, based on a change in apparent power of the second power which is measured by the power measuring device, before and after changing the reactive power of the first power.

In the distributed power generation system, the abnormality detector may detect the abnormality plural times and may determine whether or not the power measuring device has the abnormality according to a result of the detection performed plural times.

Thus, misdetermination can be suppressed even when a transient change occurs in the current detected by the power measuring device, due to a noise, etc.. Therefore, reliability of a result of detected abnormality of the power measuring device can be improved.

According to the present invention, there is provided a method of operating a distributed power generation system, comprising the steps of: converting DC power from a power generation unit into AC power (hereinafter referred to as first power) and outputting the first power to a power load; measuring electric power (hereinafter referred to as second power) supplied from a power supply utility to the power load, by a power measuring device; changing reactive power of the first power; obtaining a change in the second power measured by the power measuring device before and after changing the reactive power of the first power; and detecting an abnormality of the power measuring device based on a change in the reactive power of the first power and a change in the second power.

Thus, it is possible to determine the abnormality of the power measuring device mainly by control performed with respect to the power converter, without controlling the power generation unit, for example. That is, in the operation method of the distributed power generation system of the present invention, by an easy operation, it is possible to detect the abnormality of the power measuring device for measuring electric power supplied from the power supply utility interactively connected to the distributed power generation system.

Hereinafter, embodiments of the present invention will be described with reference to the drawings. Note that the present invention is not limited to the embodiments described below.

### (Embodiment 1)

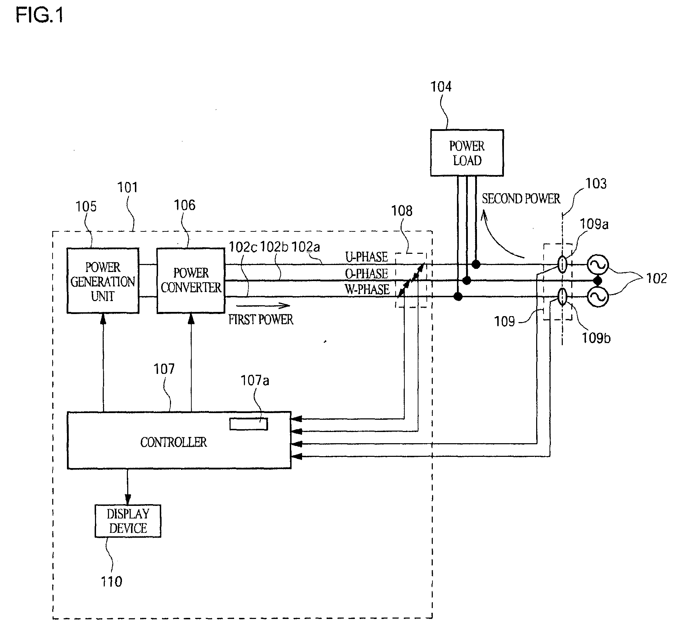

Fig. 1 is a block diagram of a distributed power generation system according to Embodiment 1 of the present invention. Fig. 1 shows a distributed power generation system 101, a power supply utility 102, and a power load 104.

As shown in Fig. 1, the power supply utility 102 is a single-phase three-wire AC power supply including a first electric wire 102a, a second electric wire 102b, and a third electric wire 102c. The power supply utility 102 is interactively connected to the distributed power generation system 101 at an interconnection point 103. The power load 104 is, for example, a television, an air-conditioner, etc., used at home, and is a device which consumes AC power supplied from the distributed power generation system 101 or the power supply utility 102. Hereinafter, the first electric wire 102a will also be referred to as U-phase, the second electric wire 102b will also be referred to as W-phase and the third electric wire 102c will also be referred to as O-phase which is a neutral wire.

The distributed power generation system 101 of the present embodiment includes at least a power generation unit 105, a power converter 106, a controller (abnormality detector) 107, a voltage detector 108, a current detector 109, and a display device 110. Among these components, the voltage detector 108 and the current detector 109 constitute a power measuring device for measuring the electric power supplied from the power supply utility 102.

The power generation unit 105 is configured to generate DC power. As the power generation unit 105, for example, a fuel cell which generates water and the DC power by causing oxygen and hydrogen to chemically react with each other, may be used. The power converter 106 converts the DC power generated in the power generation unit 105 into AC power which can be consumed by the power load 104, and output the AC power to the power load 104.

The controller 107 is a processor including a built-in nonvolatile memory 107a. The controller 107 has a power generation mode and a diagnostic mode (abnormality detection mode) as operation modes. In the power generation mode, the controller 107 controls the power generation unit 105 and the power converter 106 based on a power value which is calculated as a product of a voltage value detected by the voltage detector 108 and a current value detected by the current detector 109. In the diagnostic mode, the controller 107 diagnoses whether or not the power measuring device has an abnormality as will be described later. The power generation mode and the diagnostic mode are operation modes which can be executed concurrently in parallel. The controller 107 may be constituted by a single processor, a single logic circuit, etc., or a plurality of controllers including, for example, a controller operating in the power generation mode and a controller operating in the diagnostic mode.

The voltage detector 108 detects a voltage between the U-phase 102a and the O-phase 102c, and a voltage between the W-phase 102b and the O-phase 102c in the power supply utility 102. The current detector 109 is attached on the interconnection point 103 of the power supply utility 102 and the distributed power generation system 101, and detects a magnitude and a positive/negative sign of a current flowing through each of the electric wires. Hereinafter, it is supposed that the current detector attached on the interconnection point 103 of the U-phase 102a is a first current detector 109a, while the current detector 109 attached on the interconnection point 103 of the W-phase 102b is a second current detector 109b. The display device 110 is constituted by an LCD, a 7-segment display, etc., and displays abnormalities, operation information, etc..

### (Description of diagnostic mode)

Next, an operation of the distributed power generation system 101 in the diagnostic mode and its action will be described. Hereinafter, in particular, diagnostic process of the connected state of the current detector 109 will be described by way of example.

The distributed power generation system 101 always detects the electric power at the interconnection point 103 during a power generation operation. If it is determined that a reverse power flow has occurred based on the power value detected during the operation, the controller 107 decreases the output of the power converter 106 to obviate the reverse power flow. Also, the distributed power generation system 101 presents information to the user, based on the detected electric power, for example, by displaying the electric power (i.e., electric power purchased from a power company) flowing from the power supply utility 101 to the power load 104. Therefore, to enable the controller 107 to obtain a correct power value, it is necessary to perform the diagnostic process as to whether or not the power measuring device has an abnormality. Especially, it is necessary to diagnose the connected state between the controller 107 and the current detector 109, such as a failure of the current detector 109 and a disconnection of the electric wire. The distributed power generation system 101 of the present embodiment is configured to carry out the diagnostic process on a regular basis (e.g., every one hour).

During the power generation in the power generation unit 105, the controller 107 which is not in the diagnostic mode, controls the output of the power converter 106 so that a power (phase) factor reaches 1. Specifically, the controller 107 causes a current phase of the electric power (first power) output from the power converter 106 to conform to a voltage phase of the electric power (second power) from the power supply utility 102.

In the diagnostic process of the connected state of the current detector 109, the controller 107 changes a phase of a current output from the power converter 106 and increases a magnitude (maximum value) of the current according to the phase change in the current. Specifically, the controller 107 executes control so that I2 reaches a value satisfying I2 = I1/ cosϕ when a magnitude of the current before the phase change is I1, a magnitude of the current after the phase change is I2, and a change amount of the phase difference between the current and the voltage is ϕ. Thereby before and after the phase change, active power (active power P = V · I · cosϕ) output from the power converter 106 becomes constant.

That is, before and after the phase change, the power converter 106 is able to supply the active power with a constant magnitude to the power load 104. Therefore, the power generation unit 105 is able to maintain the electric power generated in power generation at a constant magnitude. This eliminates a need to control the output of the power generation unit 105 separately in the diagnostic process.

By comparison, when the current output from the power converter 106 changes from a state with the power factor of 1 to a state of the phase difference ϕ, the power converter 106 outputs reactive power. That is, since the reactive power is supplied from the power converter 106, the reactive power at the interconnection point 103 changes and hence the current value at the interconnection point 103 changes.

As described above, in the diagnostic process, the distributed power generation system 101 changes the reactive power while maintaining the active power at a constant value. And, by utilizing the change in the reactive power, the connected state of the current detector 109 is diagnosed.

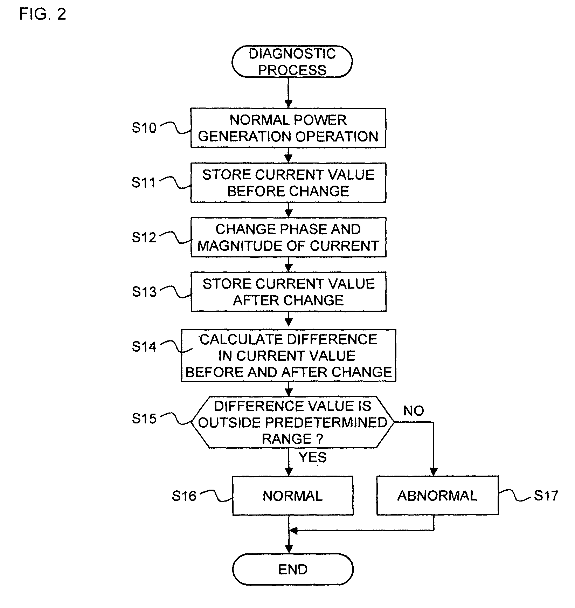

Fig. 2 is a flowchart showing the diagnostic process of the connected state of the current detector 109 which is performed by the distributed power generation system 101 according to the present embodiment. Hereinafter, the flow of the diagnostic process will be described with reference this flowchart. In the present embodiment, the diagnostic process for the first current detector 109a will be described. However, the diagnostic process for the second current detector 109b may be performed in the same manner. The diagnostic process for the first current detector 109a and the diagnostic process for the second current detector 109b will be executed concurrently in parallel or in a sequential manner.

The controller 107 executes the diagnostic process in a state in which the distributed power generation system 101 is performing a normal power generation operation (step S10). Specifically, the controller 107 stores in the built-in memory 107a, a current value (e.g., maximum value) detected by the first current detector 109a, before changing the phase and magnitude of the current output from the power converter 106 (step S11). Then, the controller 107 changes the phase and magnitude of the current output from the power converter 106 (step S 12). After the change, the controller 107 stores in the built-in memory 107a, a current value (e.g., maximum value) detected by the first current detector 109a (step S13). After storing the current value in step S13, the phase and magnitude of the current output from the power converter 106 may be returned to initial ones at a suitable timing.

Then, the controller 107 calculates a difference between the current value stored in the built-in memory 107a before changing the phase and magnitude of the current output from the power converter 106 and the current value stored in the built-in memory 107a after changing the phase and magnitude of the current output from the power converter 106 (step S 14). Then, the controller 107 determines whether or not the calculated difference value is outside a predetermined range (step S15). If it is determined that the difference is outside the predetermined range (step S15: YES), the controller 107 determines that the connected state of the first current detector 109a is normal (step S16). On the other hand, if it is determined that the calculated difference value is within the predetermined range (step S15: NO), the controller 107 determines that the connected state of the first current detector 109a is abnormal (step S 17).

In other words, the controller 107 determines that the connected state of the current detector 109 is normal when the change in the phase and the change in the magnitude of the current output from the power converter 106 are synchronized with the change in the current value detected by the current detector 109. On the other hand, the controller 107 determines that the connected state of the current detector 109 is abnormal when the change in the phase and the change in the magnitude of the current output from the power converter 106 are not synchronized with the change in the current value detected by the current detector 109.

In the present embodiment, if it is determined that the connected state of the current detector 109 is normal (step S16), the controller 107 continues power generation. On the other hand, if it is determined that the connected state of the current detector 109 is abnormal (step S17), the controller 107 causes the power generation unit 105 to stop power generation, and displays an abnormality message on the display device 110 to notify the user that the connected state between the controller 107 and the current detector 109 is abnormal.

Instead of notifying the user that the connected state is abnormal, by using the display device 110, information may be transmitted to a maintenance terminal via a communication line (not shown) to notify a maintenance company (operator) that the connected state is abnormal.

As described above, in the present embodiment, by an easy operation, it is possible to detect the abnormality of the power measuring device for measuring the electric power supplied from the power supply utility interactively connected to the distributed power generation system 101. In addition, it is possible to diagnose the connected state of the current detector 109 without reducing the amount of the active power supplied from the distributed power generation system 101 to the power load 104.

Especially in a case where a fuel cell unit including a hydrogen generator which re-uses an anode off-gas as a combustion fuel is used as the power generation unit 105, no reduction in the active power is effective. If the active power reduces, an amount of hydrogen in the anode off-gas increases, which results in an increase in an amount of heat in the hydrogen generator. In this case, a steady operation state of the hydrogen generator is impaired, which causes a need for control for ensuring a stable operation state. The fact that the active power does not reduce is preferable, because such control becomes unnecessary.

In the present embodiment, determination as to the abnormality is performed by comparing the difference value to a predetermined threshold (the above predetermined range). Because of this, even when there is a transient change in the current value detected by the current detector 109, due to a noise, etc., the connected state of the current detector 109 can be diagnosed with high reliability.

### (Modified example)

Although the determination is performed based on one change in the phase and one change in the magnitude of the current output from the power converter 106, it may be performed based on a result of plural changes. This makes it possible to obtain a more reliable diagnostic result.

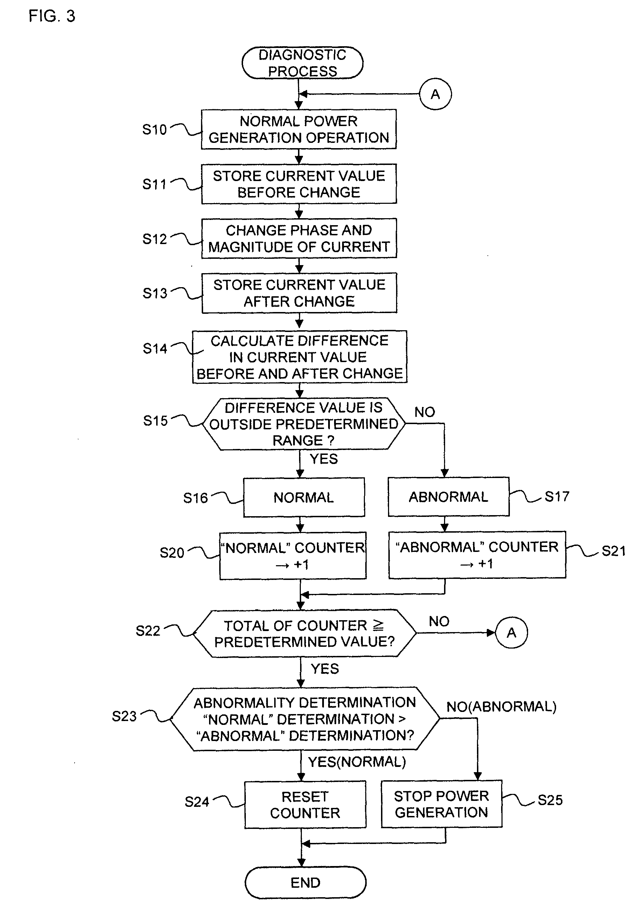

Fig. 3 is a flowchart showing a modified example of the diagnostic process of the connected state of the current detector 109 which is performed by the distributed power generation system 101 according to Embodiment 1. In the diagnostic process shown in Fig. 3, steps similar to the above stated steps S10 to S 17 are performed. If it is determined that the connected state is normal (normal state is detected) (step S16), an accumulated value of the number of times of a determination result "normal" is stored in a predetermined area of the built-in memory 107a (step S20). On the other hand, if it is determined that the connected state is abnormal (abnormal state is detected) (step S17), an accumulated value of the number of times of a determination result "abnormal" is stored in a predetermined area of the built-in memory 107a (step S21).

After finishing step S20 or step S21, the controller 107 determines whether or not a total of the accumulated value of "normal" and the accumulated value of "abnormal" has reached a predetermined value (e.g., 4) (step S22). If it is determined that the total has not reached the predetermined value yet (step S22: NO), step S10 and the following steps are performed again. On the other hand, if it is determined that the total has reached the predetermined value (step S22: YES), final determination as to abnormality is performed based on whether or not the accumulated value of "normal" and the accumulated value of "abnormal" satisfy a predetermined condition (step S23). In the example shown in Fig. 3, a case where the accumulated value of "normal" is greater than the accumulated value of "abnormal" is final determination of "normal", while a case other than the above is final determination of "abnormal".

If it is determined finally as "normal" (step S23: YES), the accumulated values stored in the predetermined areas of the built-in memory 107a are reset (step S24), and the present flow ends. In this case, the power generation is continued as described above, and the diagnostic process is performed again after a passage of a predetermined time. On the other hand, if it is determined finally as "abnormal" (step S23: NO), the power generation is stopped as described above (step S25), and notification, or the like, to the user or to the maintenance company (operator) is performed suitably.

### (Embodiment 2)

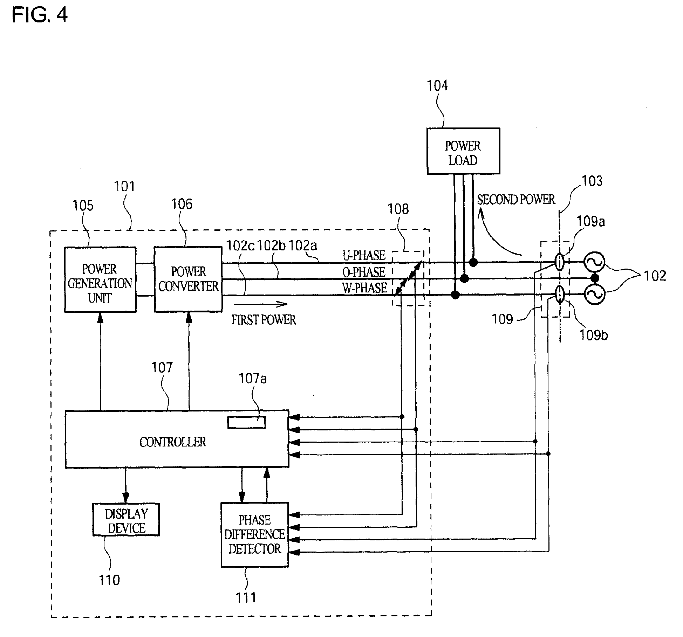

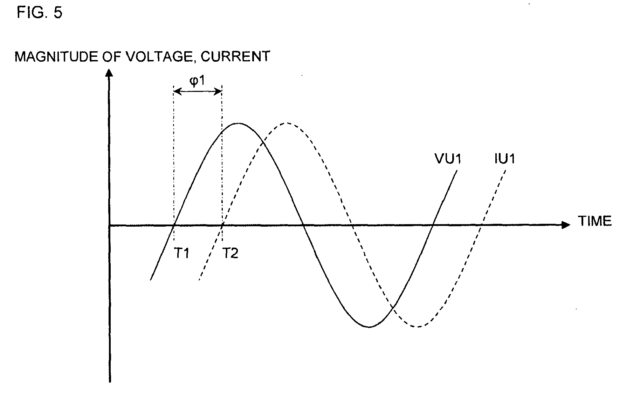

Fig. 4 is a block diagram of a distributed power generation system according to Embodiment 2 of the present invention. Fig. 4 shows the distributed power generation system 101, the power supply utility 102, and the power load 104. Fig. 5 is a graph showing an example of a relation of a phase difference between a voltage and a current which are measured by a power measuring device according to Embodiment 2. In Fig. 5, a vertical axis indicates a magnitude of the voltage or the current, while a horizontal axis indicates a time.

The distributed power generation system 101 shown in Fig. 4 is different from the distributed power generation system 101 shown in Fig. 1 in that the system 101 of Fig. 4 includes a phase difference detector 111. The phase different detector 111 obtains a voltage value from the voltage detector 108 and a current value from the current detector 109, and detects a phase difference between the voltage and the current based on the obtained values. In Fig. 4, the same components as those in Fig. 1 are identified by the same reference symbols and will not be described in detail repetitively.

Next, an operation of the distributed power generation system 101 according to Embodiment 2 in the diagnostic mode and its action will be described. Hereinafter, in particular, diagnostic process of the connected state of the current detector 109 will be described by way of example.

Firstly, a detecting method of the phase difference which is performed by the phase difference detector 111 will be described. As described above, the phase difference detector 111 receives as inputs the voltage value detected by the voltage detector 108 and the current value detected by the current detector 109. The phase difference detector 111 detects the phase difference in such a manner that, on the basis of a position at which the detected voltage value changes from a minus value to a plus value, as a reference, a difference from a position at which the detected current value changes from a minus value to a plus value is detected. The phase difference is detected for each of the U-phase 102a and the W-phase 102b. That is, the phase difference between the voltage and the current in the U-phase 102a is detected based on a voltage value between the U-phase 102a and the O-phase 102c which is detected by the voltage detector 108, and the current value detected by the first current detector 109a. In the same manner, the phase difference between the voltage and the current in the W-phase 102b is detected based on a voltage value between the W-phase 102b and the O-phase 102c which is detected by the voltage detector 108, and the current value detected by the second current detector 109b.

A description will be specifically given of the detecting method of the phase difference in the U-phase 102a, based on a voltage value VU1 between the U-phase 102a and the O-phase 102c which is detected by the voltage detector 108, and a current value IU1 detected by the first current detector 109a, with reference to Fig. 5. Fig. 5 shows that the voltage value VU1 changes from a minus value to a plus value at time T1 and a current value IU1 changes from a minus value to a plus value at time T2. The phase difference detector 111 calculates the phase difference in such a manner that it obtains the time T1 and the time T2, divides a difference ϕ1 between the time T1 and the time T2 by a cycle (e.g., time interval between two successive times at which the voltage value changes from a minus value to a plus value) of a voltage which is calculated or derived in advance, and multiplies the resulting value by 360 degrees (2π radian). Alternatively, the phase difference detector 111 may obtain the time T1 and the time T2 based on a time at which the voltage changes from a plus value to a minus value and the current changes from a plus value to a minus value.

Next, description will be given of a method of diagnosing the connected state of the current detector 109 by the controller 107.

The operation of the power converter 106 in the diagnostic process is similar to that of Embodiment 1. When diagnosing the connected state of the current detector 109, the controller 107 changes a phase of the current output from the power converter 106 and increases a magnitude (maximum value) of the current according to a change in the phase of the current. Specifically, the controller 107 causes I2 to reach a value satisfying I2 = I1 /cosϕ, when a magnitude of the current before the phase change is I1, a magnitude of the current after the phase change is I2, and a change amount of the phase difference between the current and the voltage is ϕ. Thereby, before and after the phase change, the active power (active power P = V · I · cosϕ) output from the power converter 106 is constant.

Thereby, before and after the phase change, the power converter 106 can supply the active power with a constant magnitude to the power load 104. Therefore, the power generation unit 105 can maintain the electric power generated in power generation at a constant magnitude. This eliminates a need to control the output of the power generation unit 105 separately in the diagnostic process.

When the current output from the power converter 106 changes from a state of a power factor 1 to a state of a phase difference ϕ, the power converter 106 outputs reactive power. That is, the power converter 106 supplies the reactive power, so that the reactive power in the interconnection point 103 changes and the phase difference between the voltage and the current in the interconnection point 103 changes.

In the diagnostic process, the distributed power generation system 101 maintains the active power at a constant magnitude and changes the reactive power. By utilizing a change in the reactive power, the connected state of the current detector 109 is diagnosed.

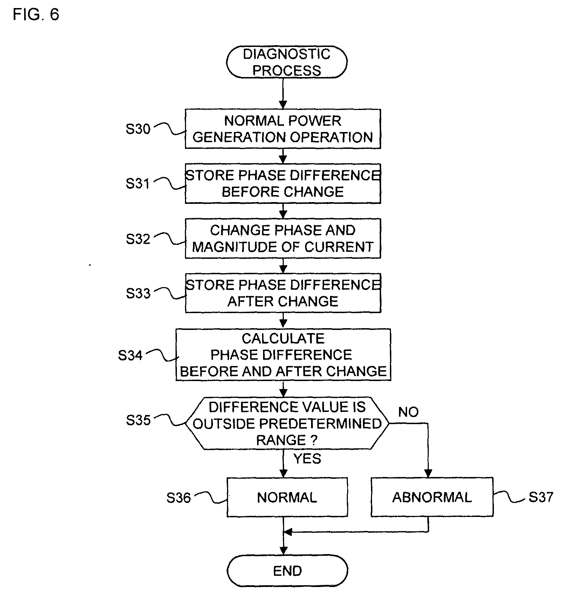

Fig. 6 is a flowchart showing the diagnostic process of the connected state of the current detector 109 which is performed by the distributed power generation system 101 according to the present embodiment. Hereinafter, the flow of the diagnostic process will be described with reference to the flowchart. Although the diagnostic process for the first current detector 109a will be described herein, the diagnostic process for the second current detector 109b will be implemented in the same manner. The diagnostic process for the first current detector 109a and the diagnostic process for the second current detector 109b may be executed concurrently in parallel or sequentially.

The controller 107 executes the diagnostic process in a state in which the distributed power generation system 101 is performing a normal power generation operation (step S30). Specifically, the controller 107 stores in the built-in memory 107a, the phase difference in the U-phase 102a which is detected by the phase difference detector 111, before changing the phase and magnitude of the current output from the power converter 106 (step S31). Then, the controller 107 changes the phase and magnitude of the current output from the power converter 106 (step S32). After the change, the controller 107 stores in the built-in memory 107a, the phase difference in the U-phase 102a which is detected by the phase difference detector 111 (step S33). After storing the phase difference in step S33, the phase and magnitude of the current output from the power converter 106 may be returned to initial ones at a suitable timing.

Then, the controller 107 calculates a difference between the phase difference stored in the built-in memory 107a before changing the phase and magnitude of the current output from the power converter 106 and the phase difference stored in the built-in memory 107a after changing the phase and magnitude of the current output from the power converter 106 (step S34). Then, the controller 107 determines whether or not the calculated difference value is outside a predetermined range (step S35). If it is determined that the difference value is outside the predetermined range (step S35: YES), the controller 107 determines that the connected state of the first current detector 109a is normal (step S36). On the other hand, if it is determined that the difference value is within the predetermined range (step S35: NO), the controller 107 determines that the connected state of the first current detector 109a is abnormal (step S37).

In other words, the controller 107 determines that the connected state of the current detector 109 is normal when the change in the phase and the change in the magnitude of the current output from the power converter 106 are synchronized with the change in the phase difference detected by the phase difference detector 111. On the other hand, the controller 107 determines that the connected state of the current detector 109 is abnormal when the change in the phase and the change in the magnitude of the current output from the power converter 106 are not synchronized with the change in the phase difference detected by the phase difference detector 111.

In the present embodiment, if it is determined that the connected state of the current detector 109 is normal (step S36), the controller 107 continues power generation. On the other hand, if it is determined that the connected state of the current detector 109 is abnormal (step S37), the controller 107 stops power generation, and displays an abnormality message on the display device 110 to notify the user that the connected state between the controller 107 and the current detector 109 is abnormal.

As described above, in the present embodiment, by an easy operation, it is possible to detect the abnormality of the power measuring device for measuring the electric power supplied from the power supply utility interactively connected to the distributed power generation system 101. In addition, it is possible to diagnose the connected state of the current detector 109 without reducing the amount of active power supplied from the distributed power generation system 102 to the power load 104. Note that the modified example of Embodiment 1 is applied to Embodiment 2.

### (Embodiment 3)

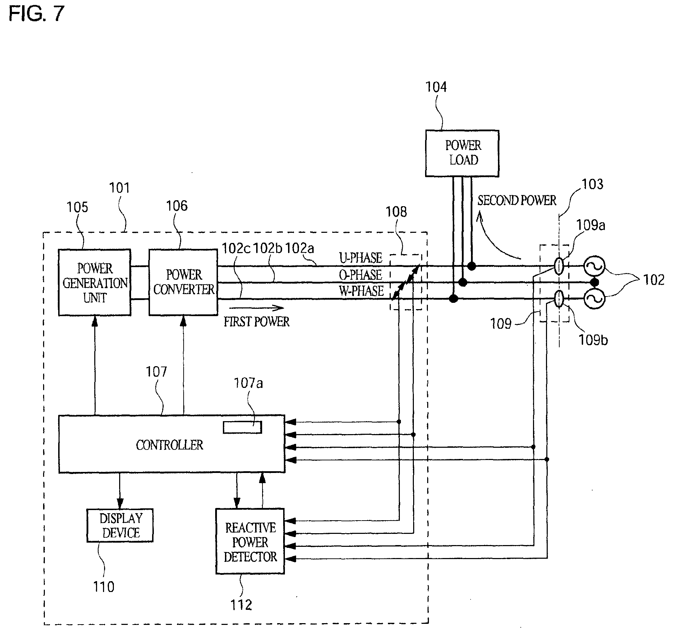

Fig. 7 is a block diagram of a distributed power generation system according to Embodiment 3 of the present invention. Fig. 7 shows the distributed power generation system 101, the power supply utility 102, and the power load 104.

The distributed power generation system 101 of Fig. 7 is different from the distributed power generation system 101 of Fig. 1 in that the system 101 of Fig. 7 includes a reactive power detector 112. The reactive power detector 112 obtains a voltage value from the voltage detector 108 and a current value from the current detector 109 and detects reactive power based on the obtained values. In Fig. 7, the same components as those of Fig. 1 are designated by the same reference symbols, and its detailed description will not be given.

Next, an operation of the distributed power generation system 101 of Embodiment 3 in the diagnostic mode and its action will be described. Hereinafter, diagnostic process of the connected state of the current detector 109 will be described by way of example.

Firstly, a description will be given of a detecting method of the reactive power by the reactive power detector 112. The reactive power detector 112 receives as inputs the the voltage value detected by the voltage detector 108 and the current value detected by the current detector 109 as described above. The reactive power detector 112 calculates the active power based on an average value of a product of an instantaneous value of the voltage and an instantaneous value of the current. In addition, the reactive power detector 112 calculates an effective value of the voltage and an effective value of the current and then calculates perform multiplication of these effective values to derive apparent power. Then, the reactive power detector 112 calculates the reactive power from a square root of a value derived by subtracting a square value of the active power from a square value of the apparent power. The reactive power is detected in each of the U-phase 102a and the W-phase 101b. That is, the reactive power in the U-phase 102a is detected from the voltage value between the U-phase 102a and the O-phase 102c which is detected by the voltage detector 108, and the current value detected by the first current detector 109a. In the same manner, the reactive power in the W-phase 102b is detected from the voltage value between the W-phase 102b and the O-phase 102c which is detected by the voltage detector 108, and the current value detected by the second current detector 109b.

Next, a description will be given of a method of diagnosing the connected state of the current detector 109 by the controller 107.

The operation of the power converter 106 in the diagnostic process is similar to that of Embodiment 1. When diagnosing the connected state of the current detector 109, the controller 107 changes a phase of the current output from the power converter 106 and increases a magnitude (maximum value) of the current according to a change in the phase of the current. Specifically, the controller 107 causes I2 to reach a value satisfying I2 = I1 /cosϕ, when a magnitude of the current before the phase change is I1, a magnitude of the current after the phase change is I2, and a change amount of the phase difference between the current and the voltage is ϕ. Thereby, before and after the phase change, the active power (active power P = V · I · cosϕ) output from the power converter 106 is constant.

Thereby, before and after the phase change, the power converter 106 supplies the active power with a constant magnitude to the power load 104. Therefore, the power generation unit 105 can maintain the electric power generated in power generation at a constant magnitude. This eliminates a need to control the output of the power generation unit 105 separately in the diagnostic process.

When the current output from the power converter 106 changes from a state of a power factor 1 to a state of a phase difference ϕ, the power converter 106 outputs reactive power. That is, the power converter 106 supplies the reactive power, so that the reactive power in the interconnection point 103 changes.

As described above, in the diagnostic process, the distributed power generation system 101 changes the reactive power, while maintaining the active power at a constant magnitude. By utilizing a change in the reactive power, the connected state of the current detector 109 is diagnosed.

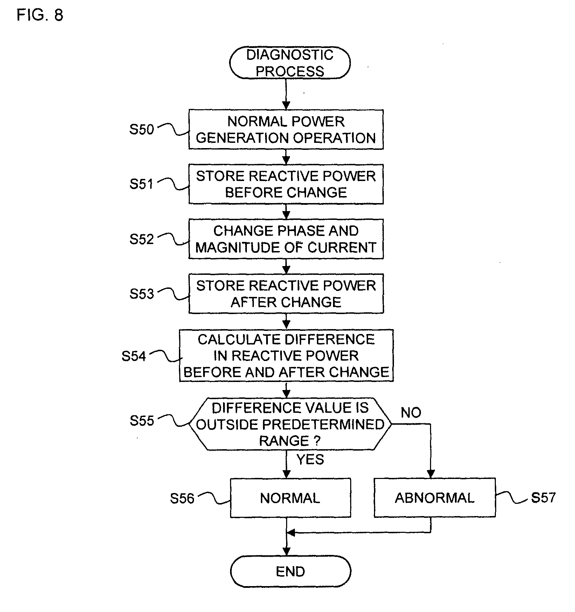

Fig. 8 is a flowchart showing the diagnostic process of the connected state of the current detector 109 which is performed by the distributed power generation system 101 of the present embodiment. Hereinafter, the flow of the diagnostic process will be described with reference to the flowchart. Although the diagnostic process for the first current detector 109a will be described herein, the diagnostic process for the second current detector 109b will be implemented in the same manner. The diagnostic process for the first current detector 109a and the diagnostic process for the second current detector 109b may be executed concurrently in parallel or sequentially.

The controller 107 executes the diagnostic process in a state in which the distributed power generation system 101 is performing a normal power generation operation (step S50). Specifically, the controller 107 stores in the built-in memory 107a, the reactive power in the U-phase 102a which is detected by the reactive power detector 112, before changing the phase and magnitude of the current output from the power converter 106 (step S51). Then, the controller 107 changes the phase and magnitude of the current output from the power converter 106 (step S52). After the change, the controller 107 stores in the built-in memory 107a, the reactive power in the U-phase 102a which is detected by the reactive power detector 112 (step S53). After storing the reactive power in step S53, the phase and magnitude of the current output from the power converter 106 may be returned to initial ones at a suitable timing.

Then, the controller 107 calculates a difference between the reactive power stored in the built-in memory 107a before changing the phase and magnitude of the current output from the power converter 106 and the reactive power stored in the built-in memory 107a after changing the phase and magnitude of the current output from the power converter 106 (step S54). Then, the controller 107 determines whether or not the calculated difference value is outside a predetermined range (step S55). If it is determined that the difference value is outside the predetermined range (step S55: YES), the controller 107 determines that the connected state of the first current detector 109a is normal (step S56). On the other hand, if it is determined that the difference value is within the predetermined range (step S55: NO), the controller 107 determines that the connected state of the first current detector 109a is abnormal (step S37).

In other words, the controller 107 determines that the connected state of the current detector 109 is normal when the change in the phase and the change in the magnitude of the current output from the power converter 106 are synchronized with the change in the reactive power detected by the reactive power detector 112. On the other hand, the controller 107 determines that the connected state of the current detector 109 is abnormal when the change in the phase and the change in the magnitude of the current output from the power converter 106 are not synchronized with the change in the reactive power detected by the reactive power detector 112.

In the present embodiment, if it is determined that the connected state of the current detector 109 is normal (step S56), the controller 107 continues power generation. On the other hand, if it is determined that the connected state of the current detector 109 is abnormal (step S57), the controller 107 stops power generation, and displays an abnormality message on the display device 110 to notify the user that the connected state between the controller 107 and the current detector 109 is abnormal.

As described above, in the present embodiment, by an easy operation, it is possible to detect the abnormality of the power measuring device for measuring the electric power supplied from the power supply utility interactively connected to the distributed power generation system 101. In addition, it is possible to diagnose the connected state of the current detector 109 without reducing the amount of active power supplied from the distributed power generation system 102 to the power load 104. Note that the modified example of Embodiment 1 is applied to Embodiment 3.

### (Modified example)

In Embodiment 3, instead of performing the diagnostic process using the reactive power value detected by the reactive power detector 112, the diagnostic process may be performed using an apparent power value detected by an apparent power detector. In this case, the reactive power detector 112 may be replaced by the apparent power detector in the distributed power generation system 101 shown in Fig. 7.

The apparent power detector calculates an effective value of the voltage and an effective value of the current based on the voltage value detected by the voltage detector 108 and the current value detected by the current detector 109, and performs multiplication of these effective values to derive the apparent power. By changing the phase and magnitude of the current output from the power converter 106, the controller 107 can change the reactive power from the power converter 106 while maintaining the active power from the power converter 106 at a constant value. As a result, the apparent power in the interconnection point 103 changes. Therefore, the connected state of the current detector 109 can be diagnosed based on the change in the apparent power. A diagnostic flow associated with the apparent power has a content in which "reactive power" in each step is replaced by "apparent power" in the flowchart of Fig. 8.

Although in Embodiment 1 to Embodiment 3, the power factor before changing the phase and magnitude of the current is 1 as described above, the present invention is applicable to a case where the power factor is less than 1. That is, by changing the phase and magnitude of the current irrespective of the power factor before change, only the reactive power output from the power converter 106 can be changed without changing the active power output from the power measuring device 106. Therefore, based on the change in the reactive power, the connected state of the current measuring device 109 can be diagnosed in the same manner as described in the above embodiments.

In a case where only the reactive power is intended to be changed, it is not necessary to change both of the phase and magnitude of the current in steps S12, S32, and S52. Specifically, in the case of the power factor of 1, the reactive power can be changed by changing at least the phase of the current. In the case of the power factor of less than 1, the reactive power can be changed by changing at least either one of the phase and magnitude of the current.

Although in Embodiment 1 to Embodiment 3, the connected state of the current measuring device 109 is diagnosed as described above, the present invention is applicable to the diagnostic process of the connected state of the voltage measuring device 108. Moreover, the power supply utility to which the present invention is applicable is not limited to the single-phase three-wire power supply utility, but is applicable to, for example, a single-phase two-wire power supply utility.

### Industrial Applicability

The present invention is applicable to a distributed power generation system which detects an abnormality of a power measuring device which measures electric power supplied from a power supply utility interactively connected to the distributed power generation system. As a result, a connected state of a current detector or the like can be diagnosed without reducing an amount of active power supplied from the distributed power generation system to a power load. Furthermore, the present invention is applicable to distributed power generation systems such as a solar light power generation apparatus, a wind power power generation apparatus, and a solar heat power generation apparatus.

### Reference Sings Lists

- 101: distributed power generation system
- 102: power supply utility
- 104: power load
- 105: power generation unit
- 106: power converter
- 107: controller
- 108: voltage detector
- 109a: first current detector
- 109b: second current detector
- 111: phase difference detector
- 112: reactive power detector

## Claims

1. A distributed power generation system interactively connected to a power supply utility (102), said distributed power generation system comprising:
a power generation unit (105) configured to generate DC power;
a power converter (106) configured to convert the DC power from the power generation unit (105) into AC power, hereinafter referred to as first power, and configured to output the first power to a power load (104);
a power measuring device configured to measure electric power, hereinafter referred to as second power, supplied from the power supply utility (102) to the power load (104);
**characterized by**
an abnormality detector (107) configured to detect an abnormality of the connected state of the power measuring device by controlling an operation of the power converter; wherein
the power measuring device includes a current measuring device (109a, 109b) configured to measure a current value of the second power and a voltage measuring device (108) configured to measure a voltage value between electric wires connecting the power converter (106) to the power supply utility (102); and
the abnormality detector (107) is configured to control the power converter (106) such that active power of the first power is maintained at a constant value and reactive power of the first power is changed, and is further configured to detect the abnormality of the power measuring device based on whether or not a change in the reactive power of the first power and a change in the second power measured by the power measuring device are synchronized with each other, when the reactive power of the first power is changed.

2. The distributed power generation system according to Claim 1,
wherein the abnormality detector (107) is configured to control the power converter (106) such that the power converter outputs the first power satisfying I2 = I1 /cosϕ, when a magnitude of a current of the first power before changing of the reactive power is I1, a magnitude of the current of the first power after changing of the reactive power is 12, and a change amount of a phase difference between the current and a voltage of the first power before and after changing of the reactive power is ϕ.

3. The distributed power generation system according to Claim 1 or 2,
wherein the abnormality detector (107) is configured to determine that the power measuring device has an abnormality when a change amount of the second power measured by the power measuring device in a case where a change in the reactive power of the first power occurs is equal to or less than a predetermined threshold.

4. The distributed power generation system according to any one of Claims 1 to 3,
wherein the abnormality detector (107) is configured to detect the abnormality of the power measuring device based on a change in a magnitude of a current of the second power, which is measured by the power measuring device before and after changing the reactive power of the first power.

5. The distributed power generation system according to any one of Claims 1 to 3,
wherein the abnormality detector (107) is configured to detect the abnormality of the power measuring device based on a change in a phase difference between a current and a voltage of the second power, which is measured by the power measuring device before and after changing the reactive power of the first power.

6. The distributed power generation system according to any one of Claims 1 to 3,
wherein the abnormality detector (107) is configured to detect the abnormality of the power measuring device based on a change in the reactive power of the second power, which is measured by the power measuring device before and after changing the reactive power of the first power.

7. The distributed power generation system according to any one of Claims 1 to 3,
wherein the abnormality detector (107) is configured to detect the abnormality of the power measuring device based on a change in apparent power of the second power, which is measured by the power measuring device before and after changing the reactive power of the first power.

8. The distributed power generation system according to any one of Claims 1 to 7,
wherein the abnormality detector (107) is configured to detect the abnormality plural times and determines whether or not the power measuring device has the abnormality according to a result of the detection performed plural times.

9. A method of operating a distributed power generation system defined in claim 1, comprising the steps of:
converting DC power from the power generation unit (105) into AC power, hereinafter referred to as first power, by power converter and outputting the first power to the power load (104);
measuring electric power, hereinafter referred to as second power, supplied from the power supply utility (102) to the power load (102), by the power measuring device;
**characterized by**
controlling the power converter (106) such that active power of the first power is maintained at a constant value and reactive power of the first power is changed;
obtaining a change in the second power measured by the power measuring device before and after changing the reactive power of the first power; and
detecting an abnormality of the connected state of the power measuring device based on whether or not a change in the reactive power of the first power and a change in the second power are synchronized with each other.

## Patentansprüche

1. System zur verteilten Stromerzeugung das interaktiv mit einem Stromversorger (102) verbunden ist, wobei das System zur verteilten Stromerzeugung umfasst:
eine Stromerzeugungseinheit (105), die zur Erzeugung von Gleichstrom konfiguriert ist;
einen Stromrichter (106), der dazu konfiguriert ist, den Gleichstrom von der Stromerzeugungseinheit (105) in Wechselstrom umzuwandeln, nachfolgend als erster Strom bezeichnet, und dazu konfiguriert ist, den ersten Strom an eine Last (104) auszugeben;
eine Strommessvorrichtung, die dazu konfiguriert ist, einen elektrischen Strom zu messen, nachfolgend als zweiter Strom bezeichnet, der von dem Stromversorger (102) an die Last (104) geliefert wird;
**gekennzeichnet durch**
einen Abnormalitätsdetektor (107), der dazu konfiguriert ist, eine Abnormaltät des Verbindungszustands der Strommessvorrichtung **durch** Kontrollieren eines Betriebs des Stromrichters zu erkennen; wobei
die Strommessvorrichtung eine Stromstärkemessvorrichtung (109a, 109b) aufweist, die dazu konfiguriert ist, einen Stromstärkewert des zweiten Stroms zu messen, und eine Spannungsmessvorrichtung (108), die dazu konfiguriert ist, einen Spannungswert zwischen elektrischen Leitungen zu messen welche den Stromrichter (106) mit dem Stromversorger (102) verbinden; und
der Abnormalitätsdetektor (107) dazu konfiguriert ist, den Stromrichter (106) so zu steuern, dass eine tatsächliche Leistung des ersten Stroms auf einem konstanten Wert gehalten wird und eine Blindleistung des ersten Stroms geändert wird, und des Weiteren dazu konfiguriert ist, die Abnormalität der Strommessvorrichtung basierend darauf zu erkennen, ob eine Änderung der Blindleistung des ersten Stroms und eine Änderung des zweiten Stroms, gemessen von der Strommessvorrichtung, miteinander synchronisiert sind oder nicht, wenn sich die Blindleistung des ersten Stroms ändert.

2. System zur verteilten Stromerzeugung nach Anspruch 1,
wobei der Abnormalitätsdetektor (107) dazu konfiguriert ist, den Stromrichter (106) zur Ausgabe des ersten Stroms derart zu steuern, dass I2 = I1 /cosψ erfüllt ist, wenn eine Größe einer Stromstärke des ersten Stroms vor der Änderung der Blindleistung I1 beträgt, eine Größe der Stromstärke des ersten Stroms nach der Änderung der Blindleistung I2 beträgt, und eine Änderung der Größe einer Phasendifferenz zwischen der Stromstärke und einer Spannung des ersten Stroms vor und nach der Änderung der Blindleistung ψ beträgt.

3. System zur verteilten Stromerzeugung nach Anspruch 1 oder 2,
wobei der Abnormalitätsdetektor (107) zum Bestimmen konfiguriert ist, dass die Strommessvorrichtung eine Abnormalität aufweist, wenn eine Änderungsgröße des zweiten Stroms, gemessen von der Strommessvorrichtung, im Falle einer Änderung der Blindleistung des ersten Stroms gleich oder kleiner als ein vorgegebener Schwellenwert ist.

4. System zur verteilten Stromerzeugung nach einem der Ansprüche 1 bis 3,
wobei der Abnormalitätsdetektor (107) dazu konfiguriert ist, die Abnormalität der Strommessvorrichtung basierend auf einer Änderung einer Größe einer Stromstärke des zweiten Stroms zu erkennen, die von der Strommessvorrichtung vor und nach der Änderung der Blindleistung des ersten Stroms gemessen wird.

5. System zur verteilten Stromerzeugung nach einem der Ansprüche 1 bis 3,
wobei der Abnormalitätsdetektor (107) dazu konfiguriert ist, die Abnormalität der Strommessvorrichtung basierend auf einer Änderung einer Phasendifferenz zwischen einer Stromstärke und einer Spannung des zweiten Stroms zu erkennen, die von der Strommessvorrichtung vor und nach der Änderung der Blindleistung des ersten Stroms gemessen wird.

6. System zur verteilten Stromerzeugung nach einem der Ansprüche 1 bis 3,
wobei der Abnormalitätsdetektor (107) dazu konfiguriert ist, die Abnormalität der Strommessvorrichtung basierend auf einer Änderung der Blindleistung des zweiten Stroms zu erkennen, die von der Strommessvorrichtung vor und nach der Änderung der Blindleistung des ersten Stroms gemessen wird.

7. System zur verteilten Stromerzeugung nach einem der Ansprüche 1 bis 3,
wobei der Abnormalitätsdetektor (107) dazu konfiguriert ist, die Abnormalität der Strommessvorrichtung basierend auf einer Änderung der Scheinleistung des zweiten Stroms zu erkennen, die von der Strommessvorrichtung vor und nach der Änderung der Blindleistung des ersten Stroms gemessen wird.

8. System zur verteilten Stromerzeugung nach einem der Ansprüche 1 bis 7,
wobei der Abnormalitätsdetektor (107) dazu konfiguriert ist, die Abnormalität zahlreiche Male zu erkennen, und entsprechend einem Ergebnis der zahlreiche Male durchgeführten Erkennung bestimmt, ob die Strommessvorrichtung die Abnormalität aufweist oder nicht.

9. Betriebsverfahren für ein System zur verteilten Stromerzeugung, wie in Anspruch 1 definiert, umfassend folgende Schritte:
Umwandeln von Gleichstrom von der Stromerzeugungseinheit (105) in Wechselstrom, nachfolgend als erster Strom bezeichnet, durch den Stromrichter und Ausgeben des ersten Stroms an eine Last (104);
Messen eines elektrischen Stroms, nachfolgend als zweiter Strom bezeichnet, der von dem Stromversorger (102) an die Last (102) geliefert wird, durch die Strommessvorrichtung;
**gekennzeichnet durch**
Steuern der Stromrichters (106) derart, dass eine tatsächliche Leistung des ersten Stroms auf einem konstanten Wert gehalten wird und eine Blindleistung des ersten Stroms geändert wird;
Erhalten einer Änderung in dem zweiten Strom, gemessen von der Strommessvorrichtung vor und nach der Änderung der Blindleistung des ersten Stroms; und
Erkennen einer Abnormalität des Verbindungszustands der Strommessvorrichtung basierend darauf, ob eine Änderung der Blindleistung des ersten Stroms und eine Änderung des zweiten Stroms miteinander synchronisiert sind oder nicht.

## Revendications

1. Système de génération de puissance distribuée connecté de manière interactive à un dispositif d'alimentation (102), ledit système de génération de puissance distribuée comprenant :
une unité de génération de puissance (105) configurée pour générer de la puissance en courant continu ;
un convertisseur de puissance (106) configuré pour convertir la puissance en courant continu de l'unité de génération de puissance (105) en puissance en courant alternatif, désignée ci-après comme première puissance, et configuré pour fournir la première puissance à une charge de puissance (104) ;
un dispositif de mesure de puissance configuré pour mesurer une puissance électrique, désignée ci-après comme deuxième puissance, fournie par le dispositif d'alimentation (102) à la charge de puissance (104) ;
**caractérisé par**
un détecteur d'anomalie (107) configuré pour détecter une anomalie de l'état connecté du dispositif de mesure de puissance en contrôlant un fonctionnement du convertisseur de puissance ; dans lequel
le dispositif de mesure de puissance comprend un dispositif de mesure de courant (109a, 109b) configuré pour mesurer une valeur de courant de la deuxième puissance et un dispositif de mesure de tension (108) configuré pour mesurer une valeur de tension entre des fils électriques qui connectent le convertisseur de puissance (106) au dispositif d'alimentation (102) ; et
le détecteur d'anomalie (107) est configuré pour contrôler le convertisseur de puissance (106) de telle sorte que la puissance active de la première puissance est maintenue à une valeur constante et qu'une puissance réactive de la première puissance est changée, et est en outre configuré pour détecter l'anomalie du dispositif de mesure de puissance sur base du fait qu'un changement de la puissance réactive de la première puissance et un changement de la deuxième puissance mesurée par le dispositif de mesure de puissance sont ou non synchronisés entre eux, lorsque la puissance réactive de la première puissance est changée.

2. Système de génération de puissance distribuée selon la revendication 1,
dans lequel le détecteur d'anomalie (107) est configuré pour contrôler le convertisseur de puissance (106) de telle sorte que le convertisseur de puissance fournisse la première puissance en répondant à la condition I2 = I1/cos ϕ, lorsqu'une grandeur d'un courant de la première puissance avant de changer la puissance réactive est I1, une grandeur du courant de la première puissance après avoir changé la puissance réactive est 12, et une valeur de changement d'une différence de phase entre le courant et une tension de la première puissance avant et après avoir changé la puissance réactive est ϕ.

3. Système de génération de puissance distribuée selon la revendication 1 ou 2,
dans lequel le détecteur d'anomalie (107) est configuré pour déterminer que le dispositif de mesure de puissance présente une anomalie lorsqu'une valeur de changement de la deuxième puissance mesurée par le dispositif de mesure de puissance, dans le cas où un changement de la puissance réactive de la première puissance se produit, est inférieure ou égale à un seuil prédéterminé.

4. Système de génération de puissance distribuée selon l'une quelconque des revendications 1 à 3,
dans lequel le détecteur d'anomalie (107) est configuré pour détecter l'anomalie du dispositif de mesure de puissance sur base d'un changement d'une grandeur de courant de la deuxième puissance, qui est mesurée par le dispositif de mesure de puissance avant et après avoir changé la puissance réactive de la première puissance.

5. Système de génération de puissance distribuée selon l'une quelconque des revendications 1 à 3,
dans lequel le détecteur d'anomalie (107) est configuré pour détecter l'anomalie du dispositif de mesure de puissance sur base d'un changement d'une différence de phase entre un courant et une tension de la deuxième puissance, qui est mesurée par le dispositif de mesure de puissance avant et après avoir changé la puissance réactive de la première puissance.

6. Système de génération de puissance distribuée selon l'une quelconque des revendications 1 à 3,
dans lequel le détecteur d'anomalie (107) est configuré pour détecter l'anomalie du dispositif de mesure de puissance sur base d'un changement de la puissance réactive de la deuxième puissance, qui est mesurée par le dispositif de mesure de puissance avant et après avoir changé la puissance réactive de la première puissance.

7. Système de génération de puissance distribuée selon l'une quelconque des revendications 1 à 3,
dans lequel le détecteur d'anomalie (107) est configuré pour détecter l'anomalie du dispositif de mesure de puissance sur base d'un changement de la puissance apparente de la deuxième puissance, qui est mesurée par le dispositif de mesure de puissance avant et après avoir changé la puissance réactive de la première puissance.

8. Système de génération de puissance distribuée selon l'une quelconque des revendications 1 à 7,
dans lequel le détecteur d'anomalie (107) est configuré pour détecter l'anomalie plusieurs fois et détermine si le dispositif de mesure de puissance présente ou non l'anomalie en fonction d'un résultat de la détection mise en oeuvre plusieurs fois.

9. Procédé de fonctionnement d'un système de génération de puissance distribuée selon la revendication 1, comprenant les étapes suivantes :
conversion de la puissance en courant continu de l'unité de génération de puissance (105) en puissance en courant alternatif, désignée ci-après comme première puissance, par un convertisseur de puissance, et fourniture de la première puissance à la charge de puissance (104) ;
mesure de l'énergie électrique, ci-après désignée comme deuxième puissance, fournie par le dispositif d'alimentation (102) à la charge de puissance (102), par le dispositif de mesure de puissance ;
**caractérisé par**
le contrôle du convertisseur de puissance (106) de telle sorte que la puissance active de la première puissance est maintenue à une valeur constante et la puissance réactive de la première puissance est changée ;
l'obtention d'un changement de la deuxième puissance mesurée par le dispositif de mesure de puissance avant et après avoir changé la puissance réactive de la première puissance ; et
la détection d'une anomalie de l'état connecté du dispositif de mesure de puissance sur base du fait qu'un changement de la puissance réactive de la première puissance et un changement de la deuxième puissance sont ou non synchronisés entre eux.
